# EUROPEAN PATENT APPLICATION

(11) **EP 3 480 865 A1**
(43) Date of publication of application: **08.05.2019**
(21) Application number: 17819368.6
(22) Date of filing: 30.06.2017
(51) Int. Cl.: H01L 51/50

(54) **NICKEL OXIDE FILM AND PREPARATION METHOD THEREFOR, FUNCTIONAL MATERIAL, MANUFACTURING METHOD FOR FILM STRUCTURE AND ELECTROLUMINESCENT DEVICE**

(30) Priority: 01.07.2016 CN 201610525274
(71) Applicant: Zhejiang University, Hangzhou, Zhejiang 310027 (CN); Najing Technology Corporation Limited, Hangzhou, Zhejiang 310052 (CN)
(72) Inventor: JIN, Yizheng, Hangzhou Zhejiang 310027 (CN); LIANG, Xiaoyong, Hangzhou Zhejiang 310027 (CN); CHEN, Chao, Hangzhou Zhejiang 310052 (CN)
(74) Representative: HGF Limited
(86) International application number: PCT/CN2017/091265
(87) International publication number: WO 2018/001372

(57) **Abstract**

The invention provides nickel oxide films and preparation method thereof, functional materials, method for fabricating film structures, and electroluminescent devices. The nickel oxide film includes: a nickel oxide film layer; organic molecules having electron withdrawing groups, the organic molecules being bonded to and disposed on the surface of the nickel oxide film layer. Due to the presence of the organic molecules having electron withdrawing groups, a reverse electric field of nickel oxide is formed on the surface of the nickel oxide, thereby improving the surface work function of the nickel oxide film. Further, when the nickel oxide film of the present application having a high surface work function is applied to the QLED device and the OLED device, the hole injection rate can be improved, thereby avoiding the use of PEDOT: PSS which is harmful to the device for improving the performance and stability of the device.

## Description

### Technical Field

The application relates to the field of optoelectronic devices, and in particular to nickel oxide film and preparation method thereof, functional materials, method for fabricating film structure, and electroluminescent device.

### Background

Transparent indium tin oxide (abbreviated in ITO) conductive film has excellent electrical conductivity and has more than 90% transmittance, and is widely used as the electrode of the optoelectronic devices such as Organic Light-Emitting Diode (abbreviated in OLED), Quantum Dot Light-Emitting Diode (abbreviated in QLED) and Organic Photovoltaic (OPV), and also as a light-transmitting window.

At present, the surface work function of conventional ITO is 4.5 eV∼4.8 eV, lower than the Highest Occupied Molecular Orbital (HOMO) of most organic functional layers of OLED, which leads to the need to overcome a high barrier in the case of hole injection as an anode, further requiring the application of a high operating voltage to the OLED device, and additionally, due to poor hole injection efficiency of conventional ITO, the device is subjected to low luminous intensity and luminous efficiency, and poor device stability. In the current fabrication technology of OLED devices, a hole injection layer such as polyethylene dioxythiophene/polystyrene sulfonate (PEDOT: PSS) is generally introduced on the ITO to match the HOMO energy level of the functional layer and the surface work function of the ITO, thereby enabling efficient injection of holes. However, the shortcoming of this method is that PEDOT: PSS is acidic and maybe corrode the ITO film during long-term use, eventually leading to a decrease in luminous efficiency and lifetime of the device.

Nickel oxide is a P-type semiconductor material with Ni²⁺ vacancies in its crystal lattice, so it exhibits the property of hole conduction. The Chinese patent with a publication No. of CN 103840047A discloses a method for preparing a layer of colloidal nickel oxide film on the surface of ITO, and uses it as a hole transport layer to assemble an OLED device, which has superior performance compared to the device with PEDOT: PSS as a hole transport layer in the same structural condition.

However, the surface work function of the nickel oxide film is about 5.0 eV, higher than the surface work function of ordinary ITO, but compared with a majority of organic hole transport materials, especially hole transport materials suitable for OLED devices and QLED devices, there is still a large gap in the HOMO energy level, causing a limited ability to improve the hole injection of the film. Therefore, how to improve the surface work function of the conductive nickel oxide film and apply it to OLED devices and QLED devices is still an urgent problem to be solved.

### Summary

The main object of the present disclosure is to provide a nickel oxide film and a preparation method thereof, a functional material, a method for fabricating a film structure, and an electroluminescent device, so as to solve the problem that the surface work function of the conductive nickel oxide film in the prior art cannot satisfy the requirements for OLED device and QLED device.

To achieve the aforesaid objective, according to one aspect of the present disclosure, there is provided a nickel oxide thin film including a nickel oxide film layer, and organic molecules having electron withdrawing groups, the organic molecules being bonded to and disposed on the surface of the nickel oxide film layer.

Further, the aforesaid organic molecules have a following structural formula (I): R-R₀-(CH₂)ₙ-P, where P is one of carboxyl group, thiol group, phosphate group, siloxy group and amine group, and P is bonded to the nickel oxide film layer; n is an integer and 0≤n≤15, preferably 0≤n≤6, R is electron withdrawing group and is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, wherein an O atom of the acylamino group is bonded to R₀, and R₀ is selected from one of alkyl group, alkenyl group, adienyl group and phenyl group.

Further, the aforesaid organic molecules have a following structural formula (I): R-R₀-(CH₂)ₙ-P, where P is one of carboxyl group, thiol group, phosphate group, siloxy group and amine group, and P is bonded to the nickel oxide of the nickel oxide film layer; n is an integer and 0≤n≤15, preferably 0≤n≤6, R comprises at least one electron withdrawing group and the electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, wherein an O atom of the acylamino group is bonded to R₀, and R₀ is selected from one of alkyl group, alkenyl group, dienyl group and phenyl group.

Further, the aforesaid organic molecules have the following structural formula: 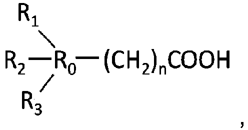 where R₀ is selected from one of C atom and phenyl group, and R₁, R₂ and R₃ are each independently selected from any one of CF₃, F, CN, NO₂, Cl, Br and I, and COOH is bonded to the nickel oxide film layer by COO⁻.

Further, the aforesaid organic molecules have the following structural formula (II): 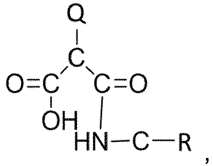 where Q is any group, and R includes at least one electron withdrawing group and the electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group.

Further, the aforesaid organic molecules have the following structural formula: 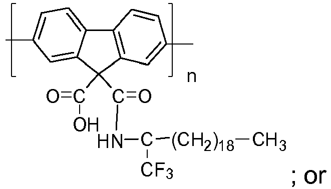 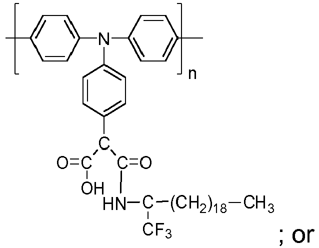 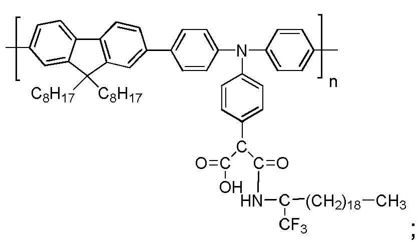 or 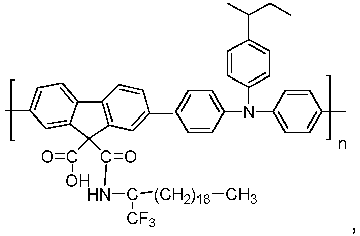 n is an integer greater than or equal to 1.

According to another aspect of the present disclosure, there is provided a functional material, including nickel oxide and organic molecules having electron withdrawing groups, the organic molecules being bonded to the nickel oxide.

Further, the aforesaid organic molecules have the following structural formula (I): R-R₀-(CH₂)ₙ-P, where P is one of carboxyl group, thiol group and phosphate group, and P is bonded to the nickel oxide; n is an integer and 0≤n≤15, preferably 0≤n≤6, R is electron withdrawing group and is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, wherein an O atom of the acylamino group is bonded to R₀, and R₀ is selected from one of alkyl group, alkenyl group, dienyl group and phenyl group.

Further, the aforesaid organic molecules have the following structural formula (I): R-R₀-(CH₂)ₙ-P, where P is one of carboxyl group, thiol group and phosphate group, and P is bonded to the nickel oxide; n is an integer and 0≤n≤15, preferably 0≤n≤6, R includes at least one of electron withdrawing groups and is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, wherein an O atom of the acylamino group is bonded to R₀, and R₀ is selected from one of alkyl group, alkenyl group, dienyl group and phenyl group.

Further, the aforesaid organic molecules have the following structural formula: 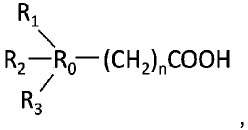 where R₀ is selected from one of C atom and phenyl group, and R₁, R₂ and R₃ are each independently selected from any one of CF₃, F, CN, NO₂, Cl, Br and I, and COOH is bonded to the nickel oxide film layer by COO⁻.

Further, the aforesaid organic molecules have the following structural formula (II): 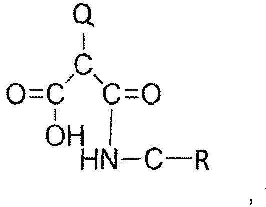 where Q is any group, and R includes at least one of electron withdrawing groups and the electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group.

Further, the aforesaid organic molecules have the following structural formula: 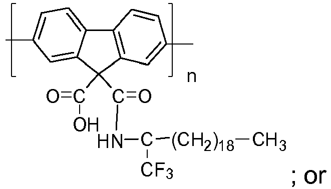 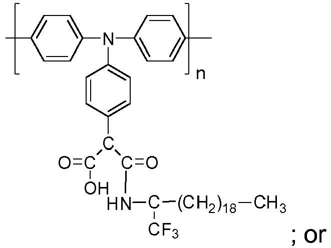 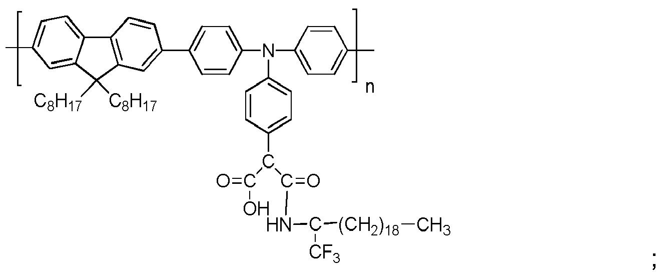 or 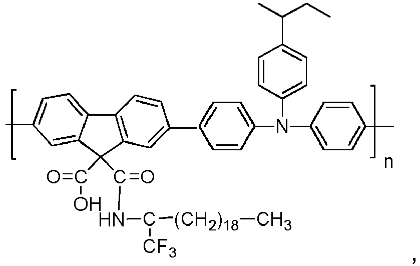 n is an integer greater than or equal to 1.

According to a further aspect of the present disclosure, there is provided a method for preparing the foresaid nickel oxide thin film, the preparation method includes: disposing a nickel oxide precursor solution on a carrier, and performing a first annealing treatment of the nickel oxide precursor solution to form a nickel oxide film layer; disposing organic molecules having electron withdrawing groups on the surface of the nickel oxide film layer; and performing a second annealing treatment of the nickel oxide film layer disposed with the organic molecules in nitrogen gas or inert gas atmosphere to obtain the nickel oxide film.

Further, the aforesaid nickel oxide precursor solution is an aqueous solution including a water-soluble nickel salt and glycine, and preferably the water-soluble nickel salt is nickel nitrate, wherein the molar ratio of the nickel nitrate to glycine is 1:10 to 1:1; or the nickel oxide precursor solution is an alcohol solution including a water-soluble nickel salt and ethanolamine, and preferably the water-soluble nickel salt is nickel acetate.

Further, the temperature of aforesaid first annealing treatment is 130 to 300 °C, and time of the treatment is 10 to 90 min.

Further, the temperature of aforesaid second annealing treatment is 80 to 180 °C and time of the treatment is 1 to 60 min.

Further, the aforesaid nickel oxide precursor solution is disposed on the carrier in a manner of coating, ink-jet printing or printing.

Further, before the surface of the nickel oxide film layer is disposed with the organic molecules having electron withdrawing groups, the preparation method further includes performing ultraviolet-ozone treatment on the nickel oxide film layer, and preferably, time of the ultraviolet-ozone treatment is 5 to 60 minutes, and an ultraviolet lamp irradiation power is 50 to 250 W.

According to a further aspect of the present disclosure, there is provided a method for preparing the foresaid nickel oxide thin film, the preparation method includes: disposing a nickel oxide solution prepared in advance on a carrier to form a nickel oxide film layer; disposing organic molecules having electron withdrawing groups on the surface of the nickel oxide film layer, after the nickel oxide film layer is subjected to ultraviolet-ozone treatment; and performing a second annealing treatment of the nickel oxide film layer disposed with the organic molecules in nitrogen gas or inert gas atmosphere to obtain the nickel oxide film.

According to a further aspect of the present disclosure, there is provided a fabrication method of a thin film structure, the film structure including a hole injection layer, a first conductive layer and a substrate, which are sequentially stacked, the first conductive layer being disposed on the substrate, wherein the fabrication method includes: using the substrate disposed with the first conductive layer as a carrier; preparing a nickel oxide film on the first conductive layer by any one of aforesaid nickel oxide film preparation methods, the nickel oxide film being the hole injection layer.

According to a further aspect of the present disclosure, there is provided an electroluminescent device including a substrate, a first conductive layer, a hole injection layer, a light-emitting layer and a second conductive layer, which are sequentially stacked, wherein the hole injection layer is any one aforesaid nickel oxide film, the nickel oxide film layer of the nickel oxide film being in contact with and disposed on the first conductive layer, the organic molecules having electron withdrawing groups being disposed on the surface of the nickel oxide film layer far from the first conductive layer.

According to the technical solution of the present disclosure, organic molecules having electron withdrawing groups are disposed on the surface of the nickel oxide film, and it is presumed based on the analysis that the anion of the organic molecules forms a chemical bond with the nickel atom of the nickel oxide film layer, and the existence of the organic molecules having electron withdrawing groups can be equivalent to establishing a reverse electric field of nickel oxide on the surface of the nickel oxide, thereby increasing the surface work function of the nickel oxide film. Further, when the nickel oxide film having a high surface work function of the present disclosure is applied to the QLED device and the OLED device, the hole injection rate may be improved, further avoiding the use of PEDOT: PSS which is harmful to the device, thereby improving the performance and stability of the device.

### Brief Description of the Drawings

The accompanying figures of the specification, constituting a part of this disclosure, are intended to provide a further understanding of the present disclosure, and the illustrative embodiments of the present disclosure and the description thereof are intended to explain the present disclosure and are not intended to limit the scope. In the accompanying figures:
FIG. 1 shows a UPS spectrum of the ITO/nickel oxide film of Embodiment 1.
FIG. 2 shows a UPS spectrum of the ITO/nickel oxide film of Comparative Embodiment 1.
FIG. 3 shows a UPS spectrum of the ITO/nickel oxide film of Embodiment 2.
FIG. 4 shows a structural diagram of QLEDs of Embodiments 17, 34, and 35.
FIG. 5 shows curves of the external quantum efficiency (EQE) of the devices of Embodiment 17 and Comparative Embodiment 2 along with the variable of operating voltage.
FIG. 6 shows curves of the brightness of the devices of Embodiment 17 and Comparative Embodiment 2 along with the variable of operating voltage.
FIG. 7 shows a UPS spectrum of the ITO/nickel oxide film of Embodiment 18.
FIG. 8 shows a UPS spectrum of the ITO/nickel oxide film of Comparative Embodiment 3.
FIG. 9 shows a UPS spectrum of the ITO/nickel oxide film of Embodiment 19.
FIG. 10 shows curves of the brightness of the devices of Embodiment 34 and Comparative Embodiment 3 along with the variable of operating voltage.
FIG. 11 shows curves of the external quantum efficiency (EQE) of the devices of Embodiment 34 and Comparative Embodiment 3 along with the variable of operating voltage.
FIG. 12 shows curves of the brightness of the devices of Embodiment 34 and Comparative Embodiment 4 along with the variable of operating voltage.
FIG. 13 shows curves of the external quantum efficiency (EQE) of the devices of Embodiment 34 and Comparative Embodiment 4 along with the variable of operating voltage.
FIG. 14 shows curves of the brightness of the devices of Embodiment 35 and Comparative Embodiment 3 along with the variable of operating voltage.
FIG. 15 shows curves of the external quantum efficiency (EQE) of the devices of Embodiment 35 and Comparative Embodiment 3 along with the variable of operating voltage.
FIG. 16 shows curves of the brightness of the devices of Embodiment 35 and Comparative Embodiment 4 along with the variable of operating voltage.
FIG. 17 shows curves of the external quantum efficiency (EQE) of the devices of Embodiment 35 and Comparative Embodiment 4 along with the variable of operating voltage.

### Detailed Description of the Embodiments

It should be noted that the embodiments in the present application and the features in the embodiments can be combined with each other without conflict. The present disclosure will be described in detail below with reference to the accompanying figures and in conjunction with the embodiments.

As analyzed by the background, the surface work function of conductive nickel oxide film in the prior art is low, which causes it to fail to meet the requirements of the OLED device and the QLED device. In order to solve this problem, the embodiments disclosed herein relate to a nickel oxide film including a nickel oxide film layer and organic molecules having electron withdrawing groups, the organic molecules being bonded to and provided on the surface of the nickel oxide film layer. It should be noted that the nickel oxide of the present disclosure is not specifically referred to as NiO, namely, not specifically referred to a nickel oxide having a molar ratio of nickel atom: oxygen atom of 1:1, and may be nickel oxide of various molar ratios. Nickel oxide in the present disclosure refers to nickel oxide nanocrystals.

The surface of the nickel oxide film provided by the present disclosure is disposed with organic molecules having electron withdrawing groups. According to the analysis, it is presumed that the anion of the organic molecules forms a stable chemical bond with the nickel atom of the nickel oxide film layer, and the existence of the organic molecules having electron withdrawing groups is equivalent to establishing a reverse electric field of nickel oxide on the surface of the nickel oxide, thereby increasing the surface work function of the nickel oxide film. Further, when the nickel oxide film having a high surface work function is applied to the QLED device and the OLED device, the hole injection rate can be improved, further avoiding the use of PEDOT: PSS which is harmful to the device, thereby improving the performance and stability of the device. Part of the organic molecules having electron withdrawing groups may enter the interior of the nickel oxide film layer due to different preparation processes.

In one or more embodiments, the aforesaid organic molecules have the following structural formula: R-R₀-(CH₂)ₙ-P, where P is one of carboxyl group, thiol group and phosphate group, and P is bonded to the nickel oxide; n is an integer and 0≤n≤15. In one or more embodiments, 0≤n≤6, R is the electron withdrawing group and is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, in which the O atom of the acylamino group is bonded to R₀, and R₀ is an alkyl group, an alkenyl group, a dienyl group or a phenyl group.

In one or more embodiments, the aforesaid organic molecules have the following structural formula: 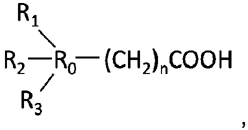 where R₀ is selected from one of C atom and a phenyl group, and R₁, R₂ and R₃ are each independently selected from any one of CF₃, F, CN, NO₂, Cl, Br and I, and COOH is bonded to the nickel oxide film layer by COO-. Or the aforesaid organic molecules have a following structural formula (I): R-R₀-(CH₂)ₙ-P, where P is one of carboxyl group, thiol group, phosphate group, siloxy group and amine group, and P is bonded to the nickel oxide of the nickel oxide film layer; n is an integer and 0≤n≤15, R includes at least one of electron withdrawing groups and the electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, where an O atom of the acylamino group is bonded to R₀, and R₀ is selected from one of alkyl group, alkenyl group, dienyl group and phenyl group. In one or more embodiments, n is an integer and 0≤n≤6.

In one or more embodiments, the aforesaid organic molecules have the following structural formula: 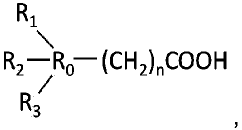 where R₀ is selected from one of C atom and phenyl group, and R₁, R₂ and R₃ are each independently selected from any one of CF₃, F, CN, NO₂, Cl, Br and I, and COOH is bonded to the nickel oxide film layer by COO⁻.

In one or more embodiments, the aforesaid organic molecules have the following structural formula (II): 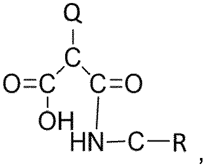 where Q is any group, and R includes at least one of electron withdrawing groups and the electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, in which COOH is bonded to the nickel oxide by COO⁻. And Q includes the group which can be bonded to C atom chemically.

In one or more embodiments, the structural formula (II) may be the following chemical structure: 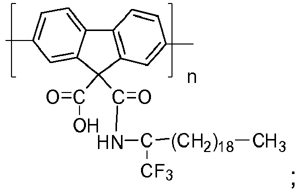 or 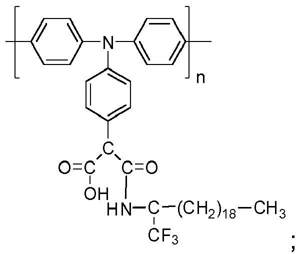 or 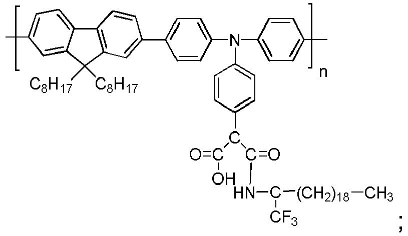 or 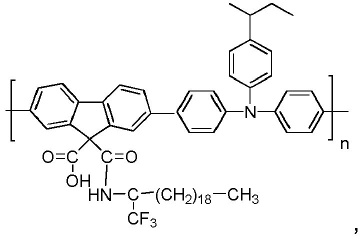 n is an integer greater than or equal to 1. In one or more embodiments, n is from 5,000 to 5,000,000, in which CF₃ is an electron withdrawing group. Suitable organic molecules can also be obtained by changing the position and number of CF₃ in each of the aforesaid structural formulas, for instance, a hydrogen atom in an alkyl group is substituted with CF₃; and suitable organic molecules can also be obtained by changing the number of alkyl groups in each of the aforesaid structural formulas.

When the organic molecules are selected from the aforesaid substances, the work function of the nickel oxide thin film can be improved, the hole injection barrier can be reduced, and the hole injection efficiency can be improved.

In another aspect, there is provided a functional material, including nickel oxide and organic molecules having electron withdrawing groups, the organic molecules being bonded to the nickel oxide.

The nickel oxide in the aforesaid functional material provided by the present disclosure is bonded to organic molecules having electron withdrawing groups. According to the analysis, it is presumed that the anion of the organic molecules (the anion may be from the P group, such as COOH) forms a stable chemical bond with the nickel of the nickel oxide, and the existence of the organic molecules having electron withdrawing groups is equivalent to establishing a reverse electric field of nickel oxide on the surface of the nickel oxide, thereby increasing the surface work function of the nickel oxide film when preparing the thin film by using the functional material. Further, when the nickel oxide film having a high surface work function of the present application is applied to the QLED device and the OLED device, the hole injection rate can be improved, further avoiding the use of PEDOT: PSS which is harmful to the device, thereby improving the performance and stability of the device.

In one or more embodiments, the aforesaid organic molecules have a following structural formula (I): R-R₀-(CH₂)ₙ-P, where P is one of carboxyl group, thiol group, phosphate group, siloxy group and amine group, and P is bonded to the nickel oxide film layer; n is an integer and 0≤n≤15, R is electron withdrawing group and is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, where an O atom of the acylamino group is bonded to R₀, and R₀ is selected from one of alkyl group, alkenyl group, adienyl group and phenyl group. In one or more embodiments, n is an integer and 0≤n≤6.

In one or more embodiments, the aforesaid organic molecules have the following structural formula: 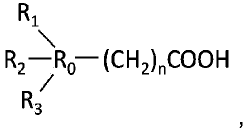 where R₀ is selected from one of C and phenyl group, and R₁, R₂ and R₃ are each independently selected from any one of CF₃, F, CN, NO₂, Cl, Br and I, and COOH is bonded to the nickel oxide film layer by COO⁻. Or the aforesaid organic molecules have a following structural formula (I): R-R₀-(CH₂)ₙ-P, where P is one of carboxyl group, thiol group, phosphate group, siloxy group and amine group, and P is bonded to the nickel oxide of the nickel oxide film layer; n is an integer and 0≤n≤15, preferably 0≤n≤6, R includes at least one of electron withdrawing groups and the electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, where an O atom of the acylamino group is bonded to R₀, and R₀ is selected from one of alkyl group, alkenyl group, dienyl group and phenyl group.

Further, the aforesaid organic molecules have the following structural formula: 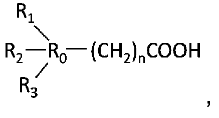 , where R₀ is selected from one of C atom and phenyl group, and R₁, R₂ and R₃ are each independently selected from any one of CF₃, F, CN, NO₂, Cl, Br and I, and COOH is bonded to the nickel oxide film layer by COO⁻.

In one or more embodiments, the aforesaid organic molecules have the following structural formula (II): 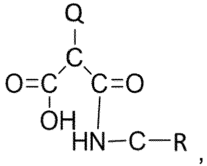 where Q is any group, and R includes at least one of electron withdrawing groups and the electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, in which COOH is bonded to the nickel oxide by COO⁻.

In one or more embodiments, the structural formula (II) may be the following chemical structure: 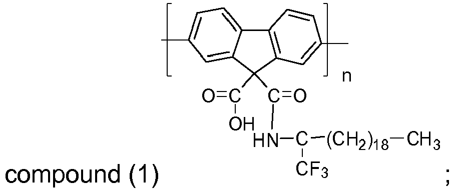 or 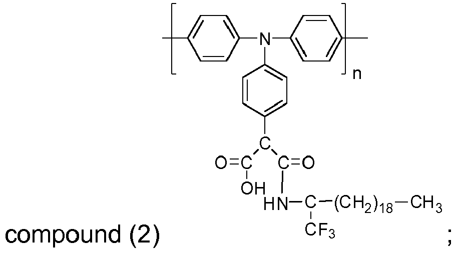 or 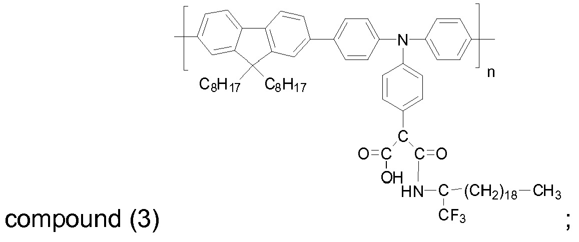 or 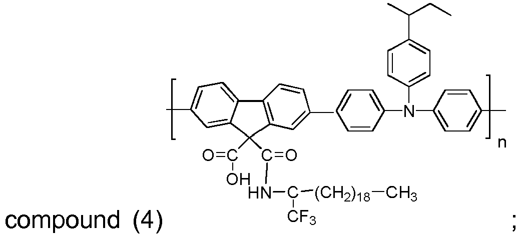 n is an integer greater than or equal to 1.

In one or more embodiments, the organic molecules in the nickel oxide film may be a mixture or a single compound satisfying one of the aforesaid structural formulas.

In another aspect, there is provided a method for preparing the aforesaid nickel oxide film, including: disposing a nickel oxide precursor solution on a carrier and performing a first annealing to form a nickel oxide film layer; disposing organic molecules on the surface of the nickel oxide film layer; and performing a second annealing treatment of the nickel oxide film layer disposed with the organic molecules in nitrogen gas or inert gas atmosphere to obtain a nickel oxide film.

Performing the first annealing of the nickel oxide precursor solution to obtain the nickel oxide film layer; and subsequently disposing organic molecules having electron withdrawing groups at its one end on the nickel oxide film layer, and the organic molecules can be dissolved in a solvent (a solvent such as methanol, ethanol, chlorobenzene, dimethyl sulfoxide, N,N-dimethylformamide, or acetone or a mixture solvent, depending on the solubility) to form organic molecules solution, and the organic molecules solution can be disposed on the nickel oxide film layer through soaking, spin coating, ink-jet printing, slit coating, etc.; and through the second annealing treatment, the anion of the organic molecules is reacted with nickel atom on the surface of the nickel oxide, and finally the electron withdrawing groups are fixed on the surface of the nickel oxide film layer by action of a covalent bond between the anion and nickel atom, thereby obtaining a functional material in the shape of the aforesaid nickel oxide film. The resulting film-like functional material can retain its original properties after changing the film-like state thereof.

The amount of the aforesaid nickel oxide precursor determines the thickness of the formed nickel oxide film layer; since the organic molecules are disposed on the surface of the nickel oxide film layer, the amount of the organic molecules added can be determined according to the area of the nickel oxide film layer. In one or more embodiments, the thickness of the nickel oxide film layer may be from 1 nm to 1000 nm.

The main function of the aforesaid nickel oxide precursor solution is to form nickel oxide, and thus the nickel oxide precursor solution used in the prior art for preparing nickel oxide can be considered for application in the present disclosure. In one or more embodiments, the aforesaid nickel oxide precursor solution is an aqueous solution including a water-soluble nickel salt and glycine. In one or more embodiments, the water-soluble nickel salt is nickel nitrate, in which the molar ratio of nickel nitrate to glycine is 1:10 to 1:1. Wherein, there is no special requirement for the concentration of nickel nitrate in the nickel oxide precursor solution. In one or more embodiments, and the concentration thereof is 0.05 to 0.1 mol/L to prepare the nickel oxide film layer having a conventional thickness. Or the nickel oxide precursor solution is an alcohol solution including a water-soluble nickel salt and an ethanolamine. In one or more embodiments, the water-soluble nickel salt is nickel acetate, in which the molar ratio of nickel acetate to ethanolamine is 1:5 to 1:0.5.

In one or more embodiments, in order to ensure that the nickel oxide precursor can be sufficiently converted into nickel oxide, the temperature of the first annealing treatment is 130 to 300 °C, and the treatment time is 10 to 90 min. The annealing usually includes a heating and insulation stage, and a cooling phase, and the temperature of the annealing treatment in the present application refers to the temperature reached after heating, and the treatment time refers to the heating time.

In one or more embodiments, in order to rapidly bind the organic molecules to the nickel oxide film layer, the temperature of the second annealing treatment is 80 to 180 °C for 1 to 60 minutes. Under the condition that the temperature is low, the annealing time can be extended appropriately.

There are various methods for disposing the nickel oxide precursor solution on the carrier, such as coating, ink-jet printing, printing, soaking, etc. In one or more embodiments, for the convenience of implementation, coating, ink-jet printing or printing is used to dispose the nickel oxide precursor solution on the carrier. The aforesaid embodiments can be applied to a large-area substrate without causing damage of the substrate, which plays a very important role on industrialization for ease of industrial production.

In one or more embodiments, before the organic molecules having electron withdrawing groups are disposed on the surface of the nickel oxide film layer, the aforesaid preparation method further includes performing ultraviolet-ozone treatment of the nickel oxide film layer, and by ultraviolet-ozone treatment of the nickel oxide film layer, a layer of hydroxyl radicals are formed on the surface of the nickel oxide film layer to provide a bond bonded with the organic molecules and strengthen the bonding force with the organic molecules; on the other hand, the nickel oxide film layer is cleaned by ultraviolet-ozone treatment to improve the bonding of the organic molecules force. Utilizing the inherent properties of the ultraviolet-ozone treated nickel oxide film layer, hydroxyl radicals are formed on the surface of the nickel oxide film layer. Therefore, those skilled in the art can select ultraviolet-ozone treatment conditions based on the equipment used and the requirements of number of hydroxyl groups. In one or more embodiments, the time of the aforesaid ultraviolet-ozone treatment is 5 to 60 minutes, and the ultraviolet lamp irradiation power is 50 to 250 W. Ultraviolet ozone treatment under the aforesaid conditions can achieve a desired treatment results in a short period of time.

In another exemplary embodiment of the present application, there is further provided another method for preparing the aforesaid nickel oxide film, including: disposing a nickel oxide solution prepared in advance (the preparation method thereof may be a method of the prior art) on the carrier to form a nickel oxide film layer; disposing organic molecules having electron withdrawing groups on the surface of said nickel oxide film layer, after the nickel oxide film layer is subjected to ultraviolet-ozone treatment; and performing a second annealing treatment of the nickel oxide film layer disposed with said organic molecules in nitrogen gas or inert gas atmosphere to obtain said nickel oxide film. Since the nickel oxide in the nickel oxide solution prepared in advance has surface ligands (the ligand may be a C₂ to C₃₀ fatty acid radical), in order to promote the chemical bonding of the organic molecules with nickel atoms, that is, to remove the nickel oxide surface ligands to expose more nickel atoms. Those skilled in the art can select the conditions of the ultraviolet-ozone treatment. In one or more embodiments, the time of the ultraviolet-ozone treatment is 5 to 60 minutes, and the ultraviolet lamp irradiation power is 50 to 250 W. Ultraviolet ozone treatment under the aforesaid conditions can achieve a desired treatment results in a short period of time. There are various methods for disposing the nickel oxide solution on the carrier, such as coating, ink-jet printing, printing, soaking, etc. In one or more embodiments, for the convenience of implementation, coating, ink-jet printing or other printing is used to dispose nickel oxide on the carrier. In one or more embodiments, in order to further remove the unbonded organic molecules, the nickel oxide film subjected to the second annealing may be washed with a cleaning solvent capable of dissolving the organic molecules.

In another exemplary embodiment of the present application, there is provided a method for fabricating a thin film structure including a hole injection layer, a first conductive layer, and a substrate which are sequentially stacked, the first conductive layer being disposed on the substrate. The fabrication method includes: using the substrate disposed with the first conductive layer as a carrier; and preparing a nickel oxide film on the first conductive layer by the aforesaid preparation method, the nickel oxide film being the hole injection layer.

The substrate disposed with the first conductive layer is used as the carrier, and then a nickel oxide film is prepared on the carrier by using a method for preparing a nickel oxide film, thereby preparing the film structure having the first conductive layer, the substrate and the nickel oxide film, the preparation method is simple. The structure can be applied to single photon light sources, solar cells, electroluminescent lighting, display devices, etc.

Since the conditions of the method for preparing the nickel oxide film of the present disclosure are mild, in one or more embodiments, the substrate material used in the aforesaid fabrication method may be a substrate commonly used in the prior art, such as glass, polymer, metal, alloy material, and one or more of the composite materials formed from the foregoing materials. Also, the material used for the first conductive layer may be a conductive oxide film layer commonly used in the prior art. In one or more embodiments, it is an ITO film.

The present disclosure further provides an electroluminescent device including a substrate, a first conductive layer, a hole injection layer, a light-emitting layer and a second conductive layer which are sequentially stacked, the hole injection layer being the aforesaid nickel oxide film, the nickel oxide film layer of the nickel oxide film being in contact with and disposed on the first conductive layer, the organic molecules having electron withdrawing groups being disposed on the surface of the nickel oxide film layer far from the first conductive layer. There may be other functional layers between the hole injection layer and the light-emitting layer, such as a hole transport layer and a hole blocking layer. There may be other functional layers between the light-emitting layer and the second conductive layer, such as one or more layers of an electron blocking layer, an electron transport layer, and an electron injecting layer.

As described above, since the nickel oxide films of the present disclosure have a high surface work function, when they are applied to the QLED devices and the OLED devices, the hole injection rate can be improved, thereby avoiding the use of PEDOT: PSS which is harmful to the device for improving the performance and stability of the device.

The aforesaid electroluminescent device may be an OLED device or a QLED device, namely, the aforesaid light-emitting layer may include any one or a combination of a group consisting of a quantum dot material, an organic fluorescent material and an organic phosphorescent material.

There are also various structures of the electroluminescent device in the prior art. In one of the embodiments, the electroluminescent device includes a substrate, a first conductive layer, a nickel oxide film (as a hole injection layer). a hole transport layer, a hole blocking layer, a light-emitting layer, an electron blocking layer, an electron transport layer, an electron injection layer, and a second conductive layer which are sequentially stacked.

In order to make the objects, technical solutions, and advantages of the present disclosure more comprehensible, the implementation method of the present disclosure will be further described in detail in conjunction with the embodiments and drawings.

### EMBODIMENTS

The quantum dot raw materials used in Embodiment 17 and Comparative Embodiment 2 are from the same production batch, and the quantum dot raw materials used in Embodiment 34, Embodiment 35, and Comparative Embodiments 3 to 4 are from another production batch having the same composition.

### Embodiment 1

S1: Nickel nitrate and glycine are dissolved in water at a molar ratio of 3:5 to prepare a nickel oxide precursor solution, wherein the concentration of nickel nitrate is 0.06 mol/L. The nickel oxide precursor is coated on an ITO substrate by spin coating (rotation speed: 4000 rpm), and the nickel oxide precursor solution is annealed in air at 200 °C for 60 min to obtain a nickel oxide film layer.

S2: The nickel oxide film layer is subjected to ultraviolet-ozone treatment for 20 min, in which the ultraviolet lamp irradiation power is 200 W, and trifluoromethyl benzoic acid in ethanol solution having a concentration of 3 mmol/L is spin coated on the ITO/nickel oxide composite film (rotation speed: 2000 rpm) in a glove box of N₂ atmosphere.

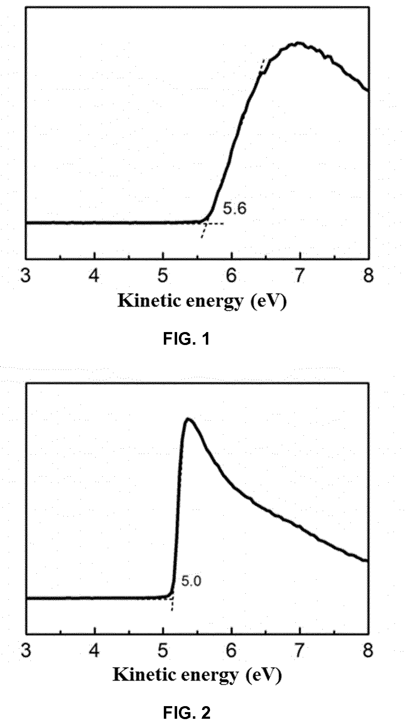

S3: In the glove box, the aforesaid film is placed on a heating panel, annealed at 120 °C for 30 min, then the surface is washed three times with ethanol, and dried to obtain a nickel oxide film, thereby obtaining a surface-modified ITO/nickel oxide composite transparent conductive film. Results of Ultraviolet photoelectron spectroscopy (abbreviated in UPS) test are shown in FIG. 1. The surface work function is 5.5 eV.

### Embodiment 2

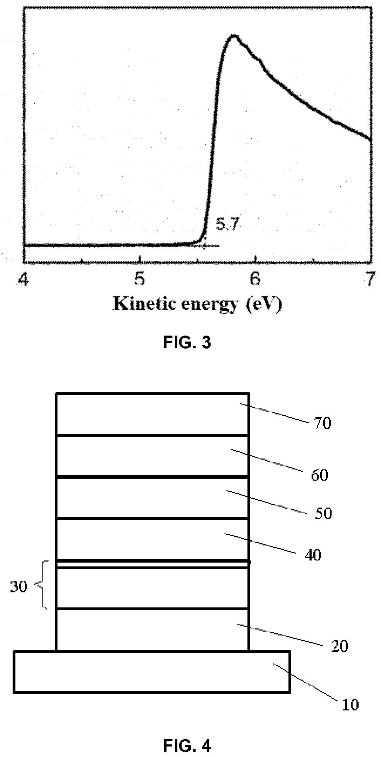

The specific steps and materials and apparatus used are the same as in Embodiment 1, except that the annealing temperature in S3 is 140 °C. The film is tested by ultraviolet photoelectric spectroscopy. The test results are shown in FIG. 3. In this embodiment, the surface work function of ITO/nickel oxide is 5.7 eV.

### Embodiment 3

The specific steps and materials and apparatus used are the same as in Embodiment 1, except that the annealing temperature in S3 is 180 °C, the annealing time is 2min. The film is tested by ultraviolet photoelectric spectroscopy. In this embodiment, the surface work function of ITO/nickel oxide is 5.7 eV.

### Embodiment 4

The specific steps and materials and apparatus used are the same as in Embodiment 1, except that the annealing temperature in S3 is 80 °C, the annealing time is 60min. The film is tested by ultraviolet photoelectric spectroscopy. In this embodiment, the surface work function of ITO/nickel oxide is 5.6 eV.

### Embodiment 5

The specific steps and materials and apparatus used are the same as in Embodiment 1, except that the annealing temperature in S3 is 200 °C. The film is tested by ultraviolet photoelectric spectroscopy. In this embodiment, the surface work function of ITO/nickel oxide is 5.7 eV.

### Embodiment 6

The specific steps and materials and apparatus used are the same as in Embodiment 1, except that the annealing temperature in S3 is 60 °C, the annealing time is 90min. The film is tested by ultraviolet photoelectric spectroscopy. In this embodiment, the surface work function of ITO/nickel oxide is 5.4 eV.

### Embodiment 7

The specific steps and materials and apparatus used are the same as in Embodiment 1, except that the compound used in S2 is trifluoromethylphenylacetic acid. The film is tested by ultraviolet photoelectric spectroscopy. In this embodiment, the surface work function of ITO/nickel oxide is 5.4 eV.

### Embodiment 8

The specific steps and materials and apparatus used are the same as in Embodiment 1, except that the compound used in S2 is trifluorobutyric acid. The film is tested by UPS after processing. In this embodiment, the surface work function of ITO/nickel oxide is 5.6 eV.

### Embodiment 9

The specific steps and materials and apparatus used are the same as in Embodiment 1, except that the annealing temperature in S1 is 100 °C, the annealing time is 90min. The film is tested by ultraviolet photoelectric spectroscopy. In this embodiment, the surface work function of ITO/nickel oxide is 5.7 eV.

### Embodiment 10

The specific steps and materials and apparatus used are the same as in Embodiment 1, except that the annealing temperature in S1 is 300 °C, the annealing time is 10min. The film is tested by ultraviolet photoelectric spectroscopy. In this embodiment, the surface work function of ITO/nickel oxide is 5.7 eV.

### Embodiment 11

The specific steps and materials and apparatus used are the same as in Embodiment 1, except that the annealing temperature in S1 is 80 °C, the annealing time is 90min. The film is tested by ultraviolet photoelectric spectroscopy. In this embodiment, the surface work function of ITO/nickel oxide is 5.7 eV.

### Embodiment 12

The specific steps and materials and apparatus used are the same as in Embodiment 1, except that nickel nitrate and glycine are dissolved in water at a molar ratio of 1:10 to prepare a nickel oxide precursor solution in S1. The film is tested by ultraviolet photoelectric spectroscopy. In this embodiment, the surface work function of ITO/nickel oxide is 5.6 eV.

### Embodiment 13

The specific steps and materials and apparatus used are the same as in Embodiment 1, except that nickel nitrate and glycine are dissolved in water at a molar ratio of 1:1 to prepare a nickel oxide precursor solution in S1. The film is tested by ultraviolet photoelectric spectroscopy. In this embodiment, the surface work function of ITO/nickel oxide is 5.7 eV.

### Embodiment 14

The specific steps and materials and apparatus used are the same as in Embodiment 1, except that nickel nitrate and glycine are dissolved in water at a molar ratio of 1:12 to prepare a nickel oxide precursor solution in S1. The film is tested by ultraviolet photoelectric spectroscopy. In this embodiment, the surface work function of ITO/nickel oxide is 5.6 eV.

### Embodiment 15

The specific steps and materials and apparatus used are the same as in Embodiment 1, except that the ultraviolet-ozone treatment time in S2 is 60min, and the ultraviolet lamp irradiation power is 50 W. The film is tested by ultraviolet photoelectric spectroscopy. In this embodiment, the surface work function of ITO/nickel oxide is 5.6 eV.

### Embodiment 16

The specific steps and materials and apparatus used are the same as in Embodiment 1, except that the ultraviolet-ozone treatment time in S2 is 5min, and the ultraviolet lamp irradiation power is 250 W. The film is tested by ultraviolet photoelectric spectroscopy. In this embodiment, the surface work function of ITO/nickel oxide is 5.6 eV.

### Embodiment 17

A Quantum Dot Light-Emitting Diode (QLED) having a structure as shown in FIG. 4, the QLED device including a substrate 10, an anode 20, and a first functional layer 30 (it should be explained that 30 in FIG. 4 is divided into two layers, which is merely for explaining that the surface of the nickel oxide film layer has been treated with organic molecules having withdrawing electron groups, and there is no actual layering), a second functional layer 40, a light-emitting layer 50, a third functional layer 60, and a cathode 70. Wherein, the substrate is a transparent glass substrate, the anode is the ITO layer of Embodiment 1, and the first functional layer 30 is the nickel oxide film of Embodiment 1, those constitute the surface-modified ITO/nickel oxide composite transparent conductive film of Embodiment 1. The second functional layer includes poly-TPD (4-butyl-N,N-diphenylaniline homopolymer) and PVK (polyvinylcarbazole). The light-emitting layer 50 is quantum dots luminescent material. The third functional layer comprises ZnO nanoparticles. Ag acts as a cathode.

### Comparative Embodiment 1

The specific steps and materials and apparatus used are the same as in S1 of Embodiment 1, and then the nickel oxide film layer is subjected to ultraviolet-ozone treatment for 20 minutes, wherein the ultraviolet lamp irradiation power is 200 W, but the subsequent S3 is not performed. The film is tested by ultraviolet photoelectric spectroscopy. The test results are shown in FIG. 2, and the surface work function is 5.0 eV.

### Comparative Embodiment 2

The specific steps and materials and instruments used are the same as in Embodiment 17, except that the first functional layer is not a nickel oxide film grown on the surface of the ITO, but a PEDOT:PSS organic molecules layer, and the surface work function of the ITO/PEDOTPSS organic molecules is 5.0 eV.

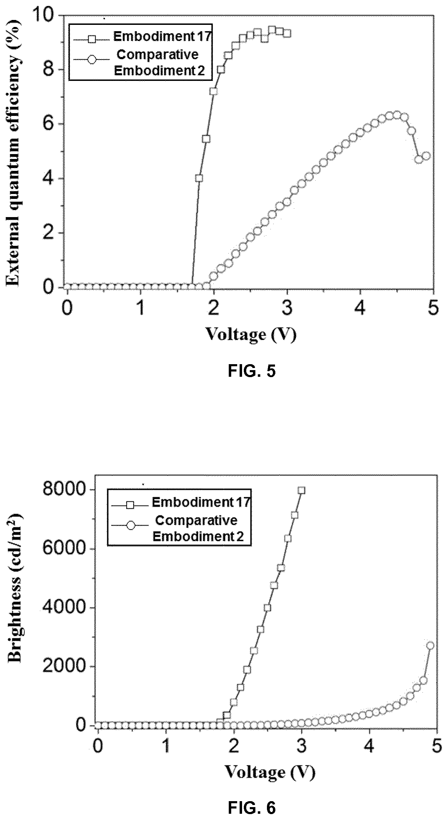

The EQE (external quantum efficiency) of the Quantum Dot Light-Emitting Diode of Embodiment 17 and Comparative Embodiment 2 is measured using a PR670 spectrophotometer/colorimeter/radiometer manufactured by PHOTO RESEARCH, at a current density of 2 mA/cm². Changes in the EQE and the brightness along with the change of operating voltage are shown in FIG. 5 and FIG. 6.

As can be seen from the comparison of Figures 1 to 3, the surface work function of the nickel oxide film prepared by the method of the present application is improved, thereby increasing the EQE and brightness of the QLED device (consistent with the results shown in FIG. 5 and FIG. 6).

### Embodiment 18

S1: Nickel nitrate and glycine are dissolved in water at a molar ratio of 3:5 to prepare a nickel oxide precursor solution, wherein the concentration of nickel nitrate is 0.06 mol/L. The nickel oxide precursor is coated on an ITO substrate by spin coating (rotation speed: 4000 rpm), and the nickel oxide precursor solution is annealed in air at 200 °C for 60 min to obtain a nickel oxide film layer.

S2: Trifluoromethyl benzoic acid inethanol solution having a concentration of 3 mmol/L is spin coated on the ITO/nickel oxide composite film (rotation speed: 2000 rpm) in a glove box of N₂ atmosphere.

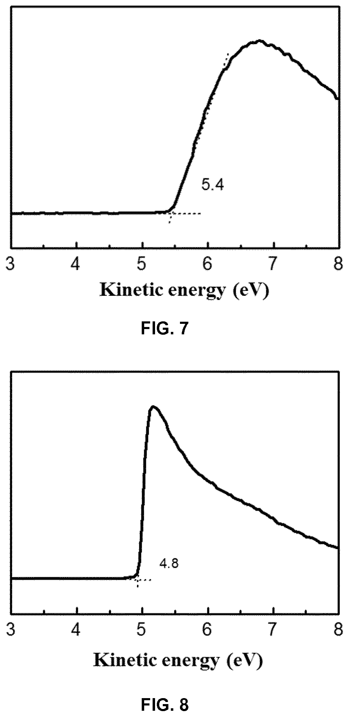

S3: In the glove box, the aforesaid film is placed on a heating panel, annealed at 120 °C for 30 min, then the surface is washed three times with ethanol, and dried to obtain a nickel oxide film, thereby obtaining a surface-modified ITO/nickel oxide composite transparent conductive film. Results of Ultraviolet photoelectron spectroscopy (abbreviated in UPS) test are shown in FIG. 7. The surface work function is 5.4 eV.

### Embodiment 19

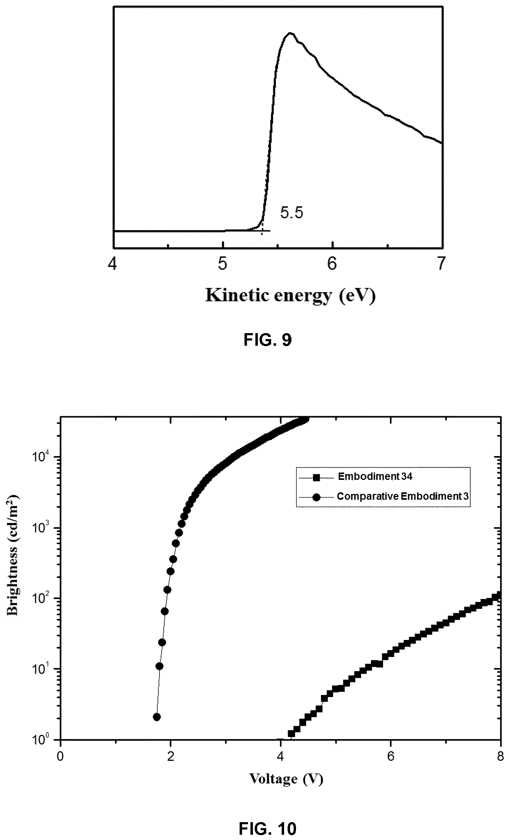

The specific steps and materials and apparatus used are the same as in Embodiment 18, except that the annealing temperature in S3 is 140 °C. The film is tested by ultraviolet photoelectric spectroscopy. The test results are shown in FIG. 9. In this embodiment, the surface work function of ITO/nickel oxide is 5.5 eV.

### Embodiment 20

The specific steps and materials and apparatus used are the same as in Embodiment 18, except that the annealing temperature in S3 is 180 °C, the annealing time is 2min. The film is tested by ultraviolet photoelectric spectroscopy. In this embodiment, the surface work function of ITO/nickel oxide is 5.3 eV.

### Embodiment 21

The specific steps and materials and apparatus used are the same as in Embodiment 18, except that the annealing temperature in S3 is 80 °C, the annealing time is 60min. The film is tested by ultraviolet photoelectric spectroscopy. In this embodiment, the surface work function of ITO/nickel oxide is 5.4 eV.

### Embodiment 22

The specific steps and materials and apparatus used are the same as in Embodiment 18, except that the annealing temperature in S3 is 200 °C. The film is tested by ultraviolet photoelectric spectroscopy. In this embodiment, the surface work function of ITO/nickel oxide is 5.3 eV.

### Embodiment 23

The specific steps and materials and apparatus used are the same as in Embodiment 18, except that the annealing temperature in S3 is 60 °C, the annealing time is 90min. The film is tested by ultraviolet photoelectric spectroscopy. In this embodiment, the surface work function of ITO/nickel oxide is 5.4 eV.

### Embodiment 24

The specific steps and materials and apparatus used are the same as in Embodiment 18, except that the compound used in S2 is trifluoromethylphenylacetic acid. The film is tested by ultraviolet photoelectric spectroscopy. In this embodiment, the surface work function of ITO/nickel oxide is 5.4 eV.

### Embodiment 25

The specific steps and materials and apparatus used are the same as in Embodiment 18, except that the compound used in S2 is trifluorobutyric acid. The film is tested by UPS after processing. In this embodiment, the surface work function of ITO/nickel oxide is 5.2 eV.

### Embodiment 26

The specific steps and materials and apparatus used are the same as in Embodiment 18, except that the annealing temperature in S1 is 100 °C, the annealing time is 90min. The film is tested by ultraviolet photoelectric spectroscopy. In this embodiment, the surface work function of ITO/nickel oxide is 5.4 eV.

### Embodiment 27

The specific steps and materials and apparatus used are the same as in Embodiment 18, except that the annealing temperature in S1 is 300 °C, the annealing time is 10min. The film is tested by ultraviolet photoelectric spectroscopy. In this embodiment, the surface work function of ITO/nickel oxide is 5.4 eV.

### Embodiment 28

The specific steps and materials and apparatus used are the same as in Embodiment 18, except that the annealing temperature in S1 is 80 °C, the annealing time is 90min. The film is tested by ultraviolet photoelectric spectroscopy. In this embodiment, the surface work function of ITO/nickel oxide is 5.3 eV.

### Embodiment 29

The specific steps and materials and apparatus used are the same as in Embodiment 18, except that nickel nitrate and glycine are dissolved in water at a molar ratio of 1:10 to prepare a nickel oxide precursor solution in S1. The film is tested by ultraviolet photoelectric spectroscopy. In this embodiment, the surface work function of ITO/nickel oxide is 5.4 eV.

### Embodiment 30

The specific steps and materials and apparatus used are the same as in Embodiment 18, except that nickel nitrate and glycine are dissolved in water at a molar ratio of 1:1 to prepare a nickel oxide precursor solution in S1. The film is tested by ultraviolet photoelectric spectroscopy. In this embodiment, the surface work function of ITO/nickel oxide is 5.3 eV.

### Embodiment 31

The specific steps and materials and apparatus used are the same as in Embodiment 18, except that nickel nitrate and glycine are dissolved in water at a molar ratio of 1:12 to prepare a nickel oxide precursor solution in S1. The film is tested by ultraviolet photoelectric spectroscopy. In this embodiment, the surface work function of ITO/nickel oxide is 5.4 eV.

### Embodiment 32

S1: Nickel acetate and ethanolamine in ethanol solution (or ethanolamine in methoxyethanol solution) are dissolved in water at a molar ratio of 3:5 to prepare a nickel oxide precursor solution, where the concentration of nickel nitrate is 0.06 mol/L. The nickel oxide precursor is coated on an ITO substrate by spin coating (rotation speed: 4000 rpm), and the nickel oxide precursor solution is annealed in air at 200 °C for 60 min to obtain a nickel oxide film layer.

S2: Trifluoromethyl benzoic acid inethanol solution having a concentration of 3 mmol/L is spin coated on the ITO/nickel oxide composite film (rotation speed: 2000 rpm).

S3: In the glove box, the aforesaid film is placed on a heating panel, annealed at 120 °C for 30 min, then the surface is washed three times with ethanol, and dried to obtain a nickel oxide film, thereby obtaining a surface-modified ITO/nickel oxide composite transparent conductive film. The film is tested by ultraviolet photoelectric spectroscopy. In this embodiment, the surface work function of ITO/nickel oxide is 5.4 eV.

### Embodiment 33

1) Weigh 1 mmol of nickel stearate, 0.2 mmol of lithium stearate as protective ligands (at a molar ratio of 5:1), 6 mmol of octadecyl alcohol and 10 ml of 1-octadecene in a 50 ml reaction flask, and perform the magnetic stirring under a protective inert atmosphere, and then evacuate the reaction system for 30 min after being heated to 50 °C.
2) Increase the temperature to 180 °C under a protective inert atmosphere, incubate for 200 min, cool the reaction solution to room temperature, and then purify by centrifugation to obtain colloidal NiO nanocrystals.
3) Dissolve the aforesaid colloidal NiO nanocrystals in octane to form a nickel oxide solution.

The above prepared 100 g/L nickel oxide solution is coated on the ITO substrate, and the ultraviolet-ozone treatment in S2 is carried out for 60 min, wherein the ultraviolet lamp irradiation power is 50 W. The film is placed on a heating panel, annealed at 150 °C for 30 min, and then the surface is washed three times with ethanol and dried to obtain a nickel oxide film, thereby obtaining a surface-modified ITO/nickel oxide composite transparent conductive film. The film is tested by ultraviolet photoelectron spectroscopy. In this embodiment, the surface work function of ITO/nickel oxide is 5.8 eV.

### Embodiment 34

A Quantum Dot Light-Emitting Diode (QLED) having a structure as shown in FIG. 4, the QLED device including a substrate 10, a first conductive layer 20, a first functional layer 30, a second functional layer 40, a light-emitting layer 50, a third functional layer 60 and a second conductive layer 70. Wherein, the substrate is a transparent glass substrate, the first conductive layer is the ITO layer of Embodiment 18, and the first functional layer 30 is the nickel oxide film of Embodiment 18, Those constitute the surface-modified ITO/nickel oxide composite transparent conductive film of Embodiment 34. The second functional layer includes poly-TPD (4-butyl-N,N-diphenylaniline homopolymer) and PVK (polyvinylcarbazole). The light-emitting layer 50 is quantum dots luminescent material. The third functional layer comprises Zn₉₀Mg₁₀O nanoparticles. Ag acts as a second conductive layer.

### Embodiment 35

A Quantum Dot Light-Emitting Diode (QLED) having a structure as shown in FIG. 4, the QLED device including a substrate 10, a first conductive layer 20, a first functional layer 30, a second functional layer 40, a light-emitting layer 50, a third functional layer 60 and a second conductive layer 70. Wherein, the substrate is a transparent glass substrate, the first conductive layer is the ITO layer of Embodiment 18, and the first functional layer 30 is the nickel oxide film of Embodiment 33. Those constitute the surface-modified ITO/nickel oxide composite transparent conductive film of Embodiment 35. The second functional layer includes poly-TPD (4-butyl-N,N-diphenylaniline homopolymer) and PVK (polyvinylcarbazole). The light-emitting layer 50 is quantum dots luminescent material. The third functional layer comprises Zn₉₀Mg₁₀O nanoparticles. Ag acts as a second conductive layer.

### Embodiment 36

S1: Nickel acetate and ethanolamine in ethanol solution (or ethanolamine in methoxyethanol solution) are dissolved in water at a molar ratio of 3:5 to prepare a nickel oxide precursor solution, where the concentration of nickel nitrate is 0.06 mol/L. The nickel oxide precursor is coated on an ITO substrate by spin coating (rotation speed: 4000 rpm), and the nickel oxide precursor solution is annealed in air at 200 °C for 60 min to obtain a nickel oxide film layer.

S2: The aforesaid compound (1) in toluene solution having a concentration of 3 mmol/L is spin coated on the ITO/nickel oxide composite film (rotation speed: 2000 rpm), in which n of the compound (1) is 500.

S3: In the glove box, the aforesaid film is placed on a heating panel, annealed at 120 °C for 30 min, then the surface is washed three times with toluene, and dried to obtain a nickel oxide film, thereby obtaining a surface-modified ITO/nickel oxide composite transparent conductive film. The film is tested by ultraviolet photoelectric spectroscopy. In this embodiment, the surface work function of ITO/nickel oxide is 5.6 eV.

### Comparative Embodiment 3

The specific steps and materials and instruments used are the same as in S1 of Embodiment 18, but subsequent S2 and S3 are not performed. The film is tested by ultraviolet photoelectron spectroscopy, and the test results are shown in FIG. 8. Its surface work function is 4.8 eV. A Quantum Dot Light-Emitting Diode (QLED) having a structure as shown in FIG. 4, the QLED device including a substrate 10, a first conductive layer 20, a first functional layer 30, a second functional layer 40, a light-emitting layer 50, a third functional layer 60 and a second conductive layer 70. Wherein, the substrate is a transparent glass substrate, the first conductive layer is the ITO layer of Embodiment 18, and the first functional layer 30 is the nickel oxide film described above in Comparative Embodiment 3. Those constitute the ITO/nickel oxide composite transparent conductive film of Comparative Embodiment 3. The second functional layer includes poly-TPD (4-butyl-N,N-diphenylaniline homopolymer) and PVK (polyvinylcarbazole). The light-emitting layer 50 is quantum dots luminescent material. The third functional layer comprises Zn₉₀Mg₁₀O nanoparticles. Ag acts as a second conductive layer.

### Comparative Embodiment 4

The specific steps and materials and instruments used are the same as in Embodiment 34, except that the first functional layer is not a nickel oxide film grown on the surface of the ITO, but a PEDOT:PSS organic molecules layer, and the surface work function of the ITO/PEDOT:PSS organic molecules is 5.0 eV.

### Comparative Embodiment 5

The specific steps and materials and apparatus used are the same as S1 in Embodiment 32, but the subsequent S2 and S3 are not performed. The film is tested by ultraviolet photoelectron spectroscopy, and the surface work function is 4.9 eV.

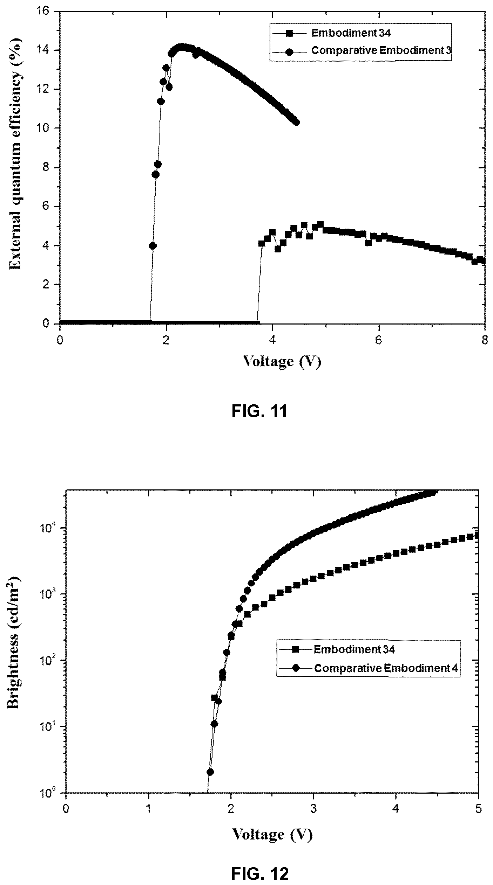

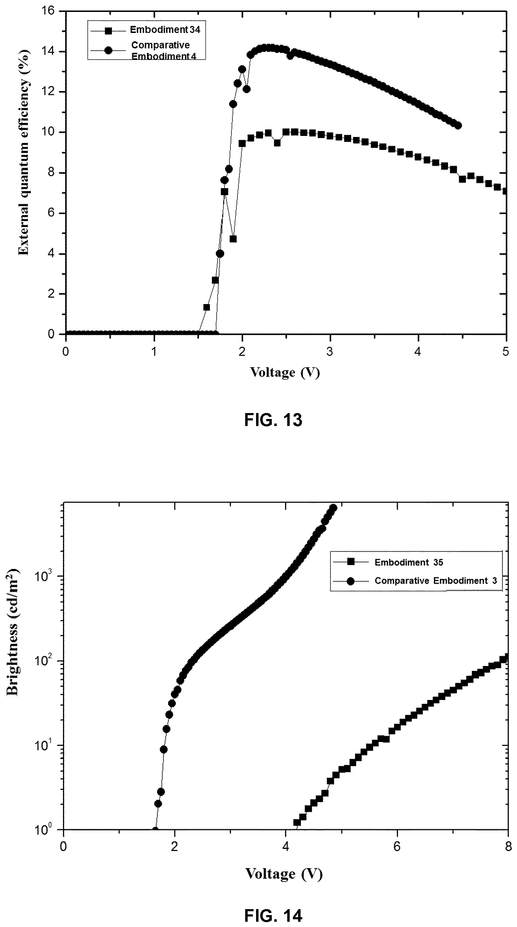

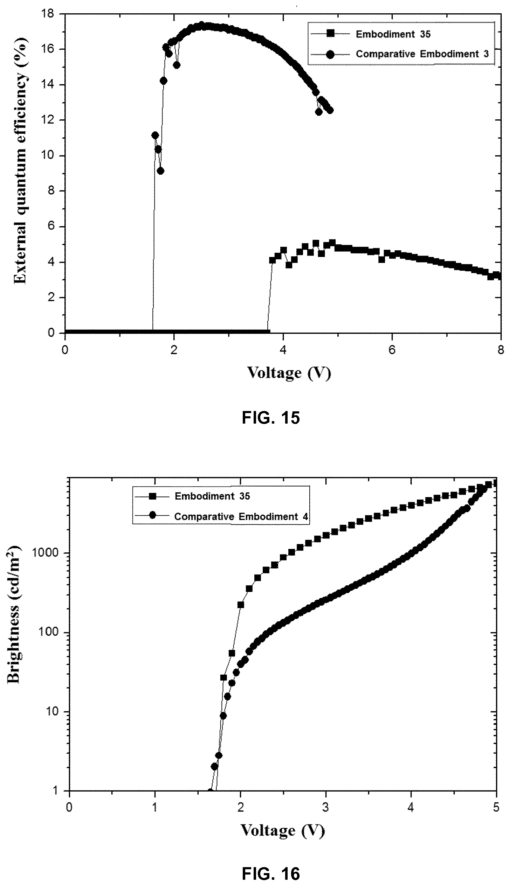

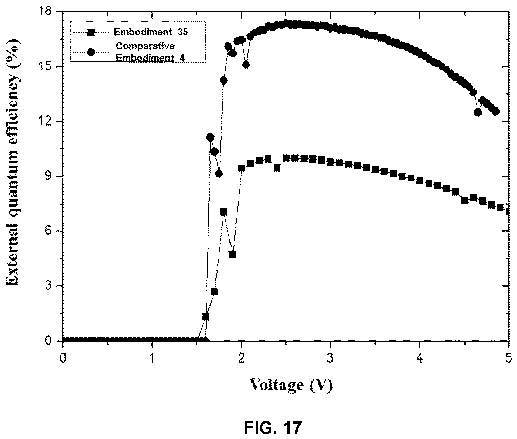

The EQE (external quantum efficiency) of the Quantum Dot Light-Emitting Diode of Embodiment 34, Embodiment 35 and Comparative Embodiment 3 and Comparative Embodiment 4 is measured using a PR670 spectrophotometer/colorimeter/radiometer manufactured by PHOTO RESEARCH, at a current density of 2 mA/cm². Changes in the EQE and the brightness along with the change of the operating voltage are shown in Figures 10 to 17.

As can be seen from the comparison of Figures 7 to 9, the surface work function of the nickel oxide film prepared by the method of the present embodiments is improved, thereby increasing the EQE and brightness of the QLED device (consistent with the results shown in Figures 10 to 17).

From the above description, it can be seen that the above-described embodiments of the present disclosure achieve the following technical effects:
The surface of the nickel oxide film of the present disclosure is provided with a layer of organic molecules having electron withdrawing groups, and the anion of the organic molecules forms a stable bonding with the nickel atom on the surface of the nickel oxide film. Due to the presence of the organic molecules having electron withdrawing groups, a reverse electric field of nickel oxide is formed on the surface of the nickel oxide, thereby improving the surface work function of the nickel oxide film. Further, when the nickel oxide film of the present application having a high surface work function is applied to the QLED device and the OLED device, the hole injection rate can be improved, thereby avoiding the use of PEDOT: PSS, which is harmful to the device for improving the performance and stability of the device.

The foregoing descriptions are merely preferred embodiments of the present disclosure and are not intended to limit the present disclosure, and for those skilled in the art, the present disclosure may have various changes and modifications. Any modification, equivalent replacement, and improvement made in the spirit and principle of the present disclosure shall fall within the protection scope of the present disclosure.

## Claims

1. A nickel oxide film, wherein said nickel oxide film comprises:
a nickel oxide film layer;
organic molecules having electron withdrawing groups, said organic molecules being bonded to and disposed on the surface of said nickel oxide film layer.

2. The nickel oxide thin film of Claim 1, wherein said organic molecules have a following structural formula (I):
R-R₀-(CH₂)ₙ-P,
wherein: P is one of carboxyl group, thiol group, phosphate group, siloxy group and amine group, and P is bonded to said nickel oxide film layer; n is an integer and 0≤n≤15, preferably 0≤n≤6, R is said electron withdrawing group and is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, wherein an O atom of said acylamino group is bonded to R₀, and R₀ is selected from one of alkyl group, alkenyl group, adienyl group and phenyl group.

3. The nickel oxide thin film of Claim 1, wherein said organic molecules have a following structural formula (I):
R-R₀-(CH₂)ₙ-P,
wherein: P is one of carboxyl group, thiol group, phosphate group, siloxy group and amine group, and P is bonded to the nickel oxide of said nickel oxide film layer;
n is an integer and 0≤n≤15, preferably 0≤n≤6, R comprises at least one of said electron withdrawing groups and said electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, wherein an O atom of said acylamino group is bonded to R₀, and R₀ is selected from one of alkyl group, alkenyl group, dienyl group and phenyl group.

4. The nickel oxide thin film of Claim 2 or 3, wherein said organic molecules have the following structural formula: 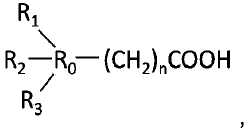 wherein, R₀ is selected from one of C atom and phenyl group, and R₁, R₂ and R₃ are each independently selected from any one of CF₃, F, CN, NO₂, Cl, Br and I, and said COOH is bonded to said nickel oxide film layer by COO-.

5. The nickel oxide thin film of Claim 1, wherein said organic molecules have the following structural formula (II): 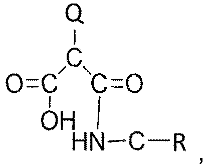 wherein, Q is any group, and R comprises at least one of said electron withdrawing groups and said electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group.

6. The nickel oxide thin film of Claim 5, wherein said organic molecules have the following structural formula: 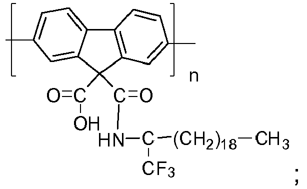 or 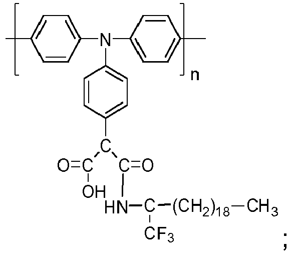 or 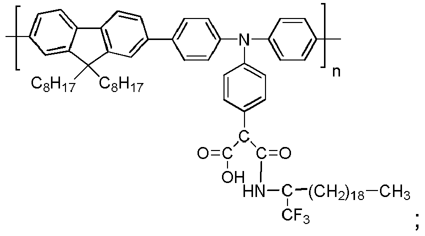 or 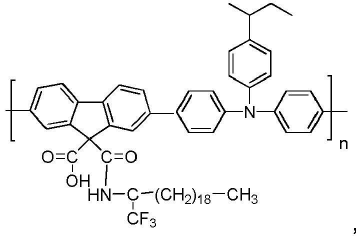 n is an integer greater than or equal to 1.

7. A functional material, comprising nickel oxide and organic molecules having electron withdrawing groups, said organic molecules being bonded to said nickel oxide.

8. The functional material of Claim 7, wherein said organic molecules have the following structural formula (I):
R-R₀-(CH₂)ₙ-P,
wherein: P is one of carboxyl group, thiol group and phosphate group, and P is bonded to said nickel oxide; n is an integer and 0≤n≤15, preferably 0≤n≤6, R is said electron withdrawing group and is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, wherein an O atom of said acylamino group is bonded to R₀, and R₀ is selected from one of alkyl group, alkenyl group, dienyl group and phenyl group.

9. The functional material of Claim 7, wherein said organic molecules have the following structural formula (I):
R-R₀-(CH₂)ₙ-P,
wherein: P is one of carboxyl group, thiol group and phosphate group, and P is bonded to said nickel oxide;
n is an integer and 0≤n≤15, preferably 0≤n≤6, R comprises at least one of said electron withdrawing groups and is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group, wherein an O atom of said acylamino group is bonded to R₀, and R₀ is selected from one of alkyl group, alkenyl group, dienyl group and phenyl group.

10. The functional material of Claim 8 or 9, wherein said organic molecules have the following structural formula: 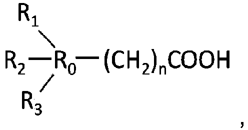 wherein R₀ is selected from one of C atom and phenyl group, and R₁, R₂ and R₃ are each independently selected from any one of CF₃, F, CN, NO₂, Cl, Br and I, and said COOH is bonded to said nickel oxide film layer by COO-.

11. The functional material of Claim 7, wherein said organic molecules have the following structural formula (II): 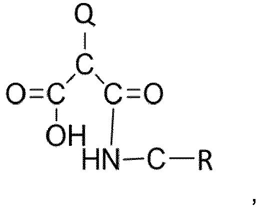 wherein, Q is any group, and R comprises at least one of said electron withdrawing groups and said electron withdrawing group is selected from one or more of the group consisting of halogen, perfluoroalkyl group, carbonyl group, carboxyl group, cyano group, ammonium group, nitro group, sulphinyl group, sulfonyl group, acylamino group, pyridinium, phosphonium, pyridyl group, thiazolyl group, oxadiazolyl group and triazolyl group.

12. The functional material of Claim 11, wherein said organic molecules have the following structural formula: 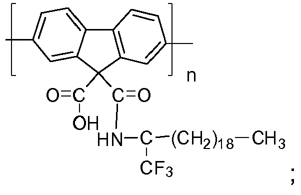 or 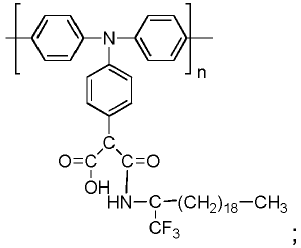 or 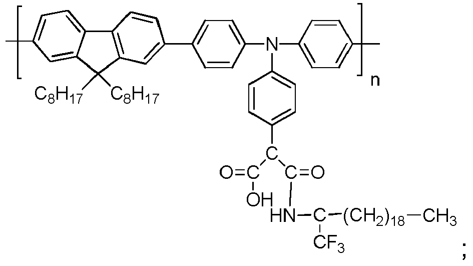 or 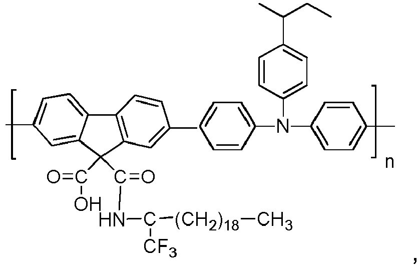 n is an integer greater than or equal to 1.

13. A preparation method of nickel oxide film of any one of Claims 1 to 6, wherein said preparation method comprises:
disposing a nickel oxide precursor solution on a carrier, and performing a first annealing treatment of said nickel oxide precursor solution to form a nickel oxide film layer;
disposing organic molecules having electron withdrawing groups on the surface of said nickel oxide film layer; and
performing a second annealing treatment of said nickel oxide film layer disposed with said organic molecules in nitrogen gas or inert gas atmosphere to obtain said nickel oxide film.

14. The preparation method of Claim 13, wherein said nickel oxide precursor solution is an aqueous solution comprising a water-soluble nickel salt and glycine, and preferably said water-soluble nickel salt is nickel nitrate, wherein the molar ratio of said nickel nitrate to glycine is 1:10 to 1:1; or said nickel oxide precursor solution is an alcohol solution comprising a water-soluble nickel salt and ethanolamine, and preferably said water-soluble nickel salt is nickel acetate.

15. The preparation method of Claim 13, wherein a temperature of said first annealing treatment is 130 to 300 °C, and the time of said treatment is 10 to 90 min.

16. The preparation method of Claim 13, wherein a temperature of said second annealing treatment is 80 to 180 °C and the time of said treatment is 1 to 60 min.

17. The preparation method of Claim 13, wherein said nickel oxide precursor solution is disposed on said carrier in a manner of coating, ink-jet printing or printing.

18. The preparation method of Claim 13, before said surface of said nickel oxide film layer is disposed with said organic molecules having electron withdrawing groups, said preparation method further comprises performing ultraviolet-ozone treatment on said nickel oxide film layer, and preferably, the time of said ultraviolet-ozone treatment is 5 to 60 minutes, and an ultraviolet lamp irradiation power is 50 to 250 W.

19. A preparation method of nickel oxide film of any one of Claims 1 to 6, wherein said preparation method comprises:
disposing a nickel oxide solution prepared in advance on a carrier to form a nickel oxide film layer;
disposing organic molecules having electron withdrawing groups on the surface of said nickel oxide film layer, after said nickel oxide film layer is subjected to ultraviolet-ozone treatment; and
performing a second annealing treatment of said nickel oxide film layer disposed with said organic molecules in nitrogen gas or inert gas atmosphere to obtain said nickel oxide film.

20. A fabrication method of a thin film structure, said film structure comprising a hole injection layer, a first conductive layer and a substrate, which are sequentially stacked, said first conductive layer being disposed on said substrate, wherein said fabrication method comprises:
using said substrate disposed with said first conductive layer as a carrier;
preparing a nickel oxide film on said first conductive layer by the preparation method according to any one of Claims 13 to 19, said nickel oxide film being said hole injection layer.

21. An electroluminescent device comprising a substrate, a first conductive layer, a hole injection layer, a light-emitting layer and a second conductive layer, which are sequentially stacked, wherein said hole injection layer is a nickel oxide film according to any one of Claims 1 to 6, the nickel oxide film layer of said nickel oxide film being in contact with and disposed on said first conductive layer, said organic molecules having electron withdrawing groups being disposed on the surface of said nickel oxide film layer far from said first conductive layer.
